# EUROPÄISCHE PATENTSCHRIFT

(11) **EP 1 771 051 B1**
(45) Veröffentlichungstag und Bekanntmachung des Hinweises auf die Patenterteilung: **27.02.2008**
(21) Anmeldenummer: 05021506.0
(22) Anmeldetag: 30.09.2005
(51) Int. Cl.: H05K 3/32, H01R 12/04

(54) **Steckkontakt und Verfahren zur Kontaktierung einer elektrischen Leitung eines spritzgegossenen Schaltungsträgers**
Male contact and process for contacting an electrical lead of an injection molded circuit substrate
Contact mâle et procédé pour contacter un conducteur électrique d'un support de circuit moulé par injection

(43) Veröffentlichungstag der Anmeldung: 04.04.2007
(73) Patentinhaber: Delphi Technologies, Inc., Troy, MI 48007 (US)
(72) Erfinder: Gärtner, Markus, 42117 Wuppertal (DE); Schmitz, Klaus Dieter, 42553 Velbert (DE)
(74) Vertreter: Manitz, Finsterwald & Partner GbR

(56) Entgegenhaltungen:
- DE-U1- 20 105 670
- GB-A- 1 188 520
- US-B1- 6 300 565

## Beschreibung

Die Erfindung betrifft einen Steckkontakt zur elektrischen Kontaktierung einer elektrischen Leitung eines spritzgegossenen Schaltungsträgers sowie ein Verfahren zur elektrischen Kontaktierung einer elektrischen Leitung eines spritzgegossenen Schaltungsträgers durch einen Steckkontakt.

Ein Steckkontakt und ein Verfahren der eingangs genannten Art sind grundsätzlich bekannt. Der Steckkontakt dient zum Beispiel zur elektrischen Verbindung der elektrischen Leitung des spritzgegossenen Schaltungsträgers, welcher auch als MID (Molded Interconnect Device) bezeichnet wird, mit einer anderen elektrischen Baueinheit, wie beispielsweise einer gedruckten Leiterplatte oder einer flexiblen gedruckten Schaltung.

Im Bereich der zu kontaktierenden elektrischen Leitung ist eine an den Steckkontakt angepasste Steckkontaktaufnahme in dem spritzgegossenen Schaltungsträger ausgebildet. Zur Kontaktierung der elektrischen Leitung wird der Steckkontakt in die Steckkontaktaufnahme des spritzgegossenen Schaltungsträgers eingesteckt und mit der elektrischen Leitung verlötet.

Ein Steckkontakt gemäß dem Oberbegriff des Anspruchs 1 ist in der GB-A-1 188 520 offenbart. Weitere Steckkontakte der eingangs genannten Art sind aus der DE-U-201 05 670 und der US-B-6 300 565 bekannt.

Der Erfindung liegt die Aufgabe zugrunde, einen Steckkontakt und ein Verfahren zu schaffen, welcher bzw. welches eine einfachere und kostengünstigere elektrische Kontaktierung einer elektrischen Leitung eines spritzgegossenen Schaltungsträgers ermöglicht.

Zur Lösung dieser Aufgabe sind ein Steckkontakt mit den Merkmalen des Anspruchs 1 und ein Verfahren mit den Merkmalen des Anspruchs 4 vorgesehen.

Der erfindungsgemäße Steckkontakt ist ein Flachstecker, der einen Kontaktvorsprung zur Ausübung einer Kontaktkraft auf einen in Richtung einer Steckkontaktaufnahme des Schaltungsträgers umgebogenen Kontaktabschnitt der elektrischen Leitung aufweist, wobei der Kontaktvorsprung an einer sich in Steckrichtung erstreckenden Breitseite des Steckkontakts angeordnet ist und an wenigstens einer sich in Steckrichtung erstreckenden Schmalseite des Steckkontakts ein Sicherungsmittel zur Sicherung des Steckkontakts in der Steckkontaktaufnahme vorgesehen ist.

Gemäß dem erfindungsgemäßen Verfahren wird die elektrische Leitung so auf dem Schaltungsträger angeordnet, dass sich ein Kontaktabschnitt der elektrischen Leitung zumindest abschnittsweise über eine in dem Schaltungsträger vorgesehene Steckkontaktaufnahme erstreckt, und der Steckkontakt derart in die Steckkontaktaufnahme eingesteckt, dass der Kontaktabschnitt der elektrischen Leitung durch den Kontaktvorsprung des Steckkontakts in Richtung der Steckkontaktaufnahme umgebogen wird und ausschließlich durch den Kontaktvorsprung des in die Steckkontaktaufnahme eingesteckten Steckkontakts eine Kontaktkraft auf den umgebogenen Kontaktabschnitt der elektrischen Leitung ausgeübt wird.

Weiterer Gegenstand der Erfindung ist außerdem ein spritzgegossener Schaltungsträger mit einer elektrischen Leitung und einem erfindungsgemäßen elektrischen Steckkontakt, welcher in eine Steckkontaktaufnahme des Schaltungsträgers eingesteckt ist und zur elektrischen Kontaktierung der elektrischen Leitung durch einen Kontaktvorsprung eine Kontaktkraft auf einen in Richtung der Steckkontaktaufnahme umgebogenen Kontaktabschnitt der elektrischen Leitung ausübt.

Der wesentliche Erfindungsgedanke besteht also darin, einen einen Kontaktvorsprung aufweisenden Steckkontakt so in die Steckkontaktaufnahme eines MID einzubringen, dass der Kontaktvorsprung auf die zu kontaktierende elektrische Leitung drückt und dadurch eine elektrische Verbindung zwischen dem Steckkontakt und der elektrischen Leitung hergestellt wird. Das Einstecken des Steckkontakts in die Steckkontaktaufnahme dient also zweierlei Zwecken, nämlich zum einen der Befestigung des Steckkontakts an dem Schaltungsträger und zum anderen der Kontaktierung der elektrischen Leitung.

Dadurch, dass erfindungsgemäß an wenigstens einer sich in Steckrichtung erstreckenden Schmalseite des Steckkontakts ein Sicherungsmittel zur Sicherung des Steckkontakts in der Steckkontaktaufnahme vorgesehen ist, wird ein sicherer Sitz des Steckkontakts in der Steckkontaktaufnahme gewährleistet und eine dauerhaft zuverlässige elektrische Verbindung von Steckkontakt und elektrischer Leitung sichergestellt. Um einen besonders sicheren Presssitz des Steckkontakts in der Steckkontaktaufnahme zu erreichen, kann das Sicherungsmittel mehrere sägezahnähnliche Vorsprünge umfassen.

Durch den Kontaktvorsprung kann der Kontaktabschnitt der elektrischen Leitung an einen die Steckaufnahme begrenzenden Randbereich des Schaltungsträgers angedrückt werden, dessen Oberfläche quer, d.h. also nicht parallel, zur Steckrichtung orientiert ist. Dadurch wird verhindert, dass der Kontaktabschnitt beim Einstecken des Steckkontakts in die Steckkontaktaufnahme von der elektrischen Leitung abgerissen wird.

Die Kontaktkraft wird ausschließlich über den Kontaktvorsprung, d.h. also lokal begrenzt, auf die elektrische Leitung ausgeübt. Durch diese Konzentration der Kontaktkraft ist der auf den Kontaktabschnitt wirkende Druck erhöht, und es wird eine zuverlässigere elektrische Verbindung zwischen Steckkontakt und elektrischer Leitung erreicht.

Die Kontaktbildung zwischen Steckkontakt und elektrischer Leitung erfolgt auf rein mechanische Weise. Durch den in die Steckkontaktaufnahme eingesteckten Steckkontakt wird der Kontaktabschnitt der elektrischen Leitung so zwischen dem Kontaktvorsprung und dem Schaltungsträger eingeklemmt, dass eine Reibschlussverbindung zwischen Steckkontakt und elektrischer Leitung geschaffen wird. Dabei wird der Steckkontakt vorteilhafterweise so fest an die elektrische Leitung angedrückt, dass der Reibschluss zwischen Steckkontakt und elektrischer Leitung gasdicht ist und eine Oxidation bzw. Korrosion der Kontaktflächen der elektrischen Leitung und des Kontaktvorsprungs verhindert wird.

Aufgrund der mechanischen Kontaktbildung zwischen Steckkontakt und elektrischer Leitung kann auf eine Verlötung von Steckkontakt und elektrischer Leitung verzichtet werden, wodurch die Kontaktierung der elektrischen Leitung erheblich vereinfacht wird.

Außerdem braucht der spritzgegossene Schaltungsträger dadurch, dass die elektrische Verbindung von Steckkontakt und elektrischer Leitung erfindungsgemäß ohne einen Lötvorgang auskommt, nicht den während eines Lötvorgangs auftretenden erhöhten Temperaturen standzuhalten. Somit können an das Spritzgussmaterial des Schaltungsträgers erfindungsgemäß geringere Temperaturanforderungen gestellt werden als an das Spritzgussmaterial solcher Schaltungsträger, bei denen eine Verlötung von Steckkontakt und elektrischer Leitung zwingend ist.

Die Anzahl der für den Schaltungsträger in Frage kommenden Spritzgussmaterialien ist dadurch erheblich vergrößert. Insbesondere lässt sich der spritzgegossene Schaltungsträger erfindungsgemäß aus einem kostengünstigeren thermoplastischen Material herstellen, wodurch die Fertigung des Schaltungsträgers mit einem geringeren wirtschaftlichen Aufwand möglich ist.

Gemäß einer vorteilhaften Ausführungsform des erfindungsgemäßen Steckkontakts weist der Kontaktvorsprung eine Breite auf, die mindestens so groß wie die Breite des Kontaktabschnitts ist. Dadurch wird eine besonders große Kontaktfläche und somit eine besonders zuverlässige elektrische Verbindung von Steckkontakt und elektrischer Leitung erreicht. Der Kontaktvorsprung kann an einer sich in Steckrichtung erstreckenden ersten Seite, insbesondere Breitseite, des Steckkontakts angeordnet sein. Dies ermöglicht die Ausbildung des Kontaktvorsprungs mit einer Breite, die so groß ist, dass eine zuverlässige Kontaktierung des Kontaktabschnitts selbst dann noch gewährleistet ist, wenn die elektrische Leitung unbeabsichtigterweise nicht exakt mit der Steckkontaktaufnahme ausgerichtet ist.

Gemäß einer vorteilhaften Ausbildung des erfindungsgemäßen Verfahrens wird die elektrische Leitung mittels eines Heißprägeverfahrens auf ein Trägermaterial des Schaltungsträgers aufgebracht. Dies ermöglicht die Herstellung des Schaltungsträgers mit einem besonders geringen wirtschaftlichen Aufwand.

Bevorzugt wird eine die elektrische Leitung tragende Heißprägefolie, insbesondere während des Heißprägevorgangs, in einem Umgebungsbereich des Kontaktbereichs der elektrischen Leitung und insbesondere entlang von Rändern des Schaltungsträgers, welche eine Einführöffnung der Steckkontaktaufnahme begrenzen, eingeschnitten oder perforiert.

Das Einschneiden bzw. Perforieren der Heißprägefolie erleichtert das Umbiegen des Kontaktabschnitts der elektrischen Leitung in Richtung der Steckkontaktaufnahme beim Einstecken des Steckkontakts. Insbesondere wird durch das Einschneiden bzw. Perforieren eine Solltrennstelle der Heißprägefolie geschaffen, die einen die Einführöffnung der Steckkontaktaufnahme überdeckenden Abschnitt der Heißprägefolie definiert, welcher beim Einführen des Steckkontakts zusammen mit dem Kontaktabschnitt der elektrischen Leitung in Richtung der Steckkontaktaufnahme umgebogen wird, ohne dass es dabei zu einem unkontrollierten Einreißen der Heißprägefolie kommt.

Das Einschneiden bzw. Perforieren der Heißprägefolie kann gleichzeitig mit dem Aufprägen der elektrischen Leitung auf das Trägermaterial des Schaltungsträgers erfolgen, so dass hierfür kein zusätzlicher Arbeitsgang erforderlich ist.

Nachfolgend wird die Erfindung rein beispielhaft anhand einer vorteilhaften Ausführungsform unter Bezugnahme auf die Zeichnung beschrieben. Es zeigen:
- Fig. 1: eine Seitenansicht eines erfindungsgemäßen Steckkontakts;
- Fig. 2: eine Querschnittsansicht eines spritzgegossenen Schaltungsträgers mit einer Steckkontaktaufnahme für den Steckkontakts von Fig. 1 und einer zu kontaktierenden elektrischen Leitung; und
- Fig. 3: eine Querschnittsansicht des Schaltungsträgers von Fig. 2 mit in die Steckkontaktaufnahme eingestecktem Steckkontakt.

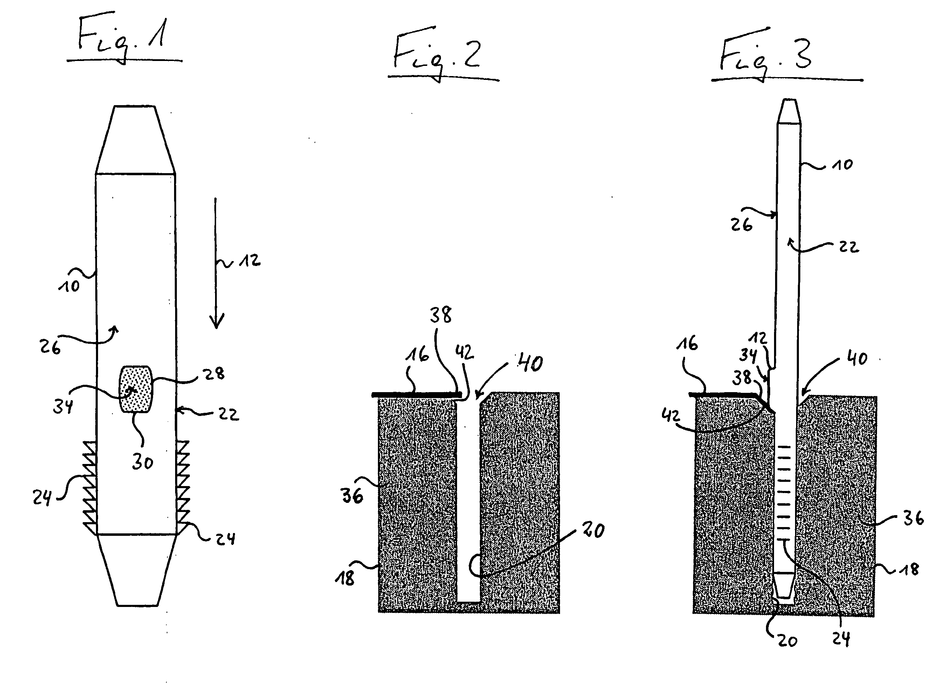

In Fig. 1 ist ein erfindungsgemäßer Steckkontakt 10 dargestellt, welcher eine im Wesentlichen quaderförmige Grundform aufweist. Bei dem dargestellten Ausführungsbeispiel weist der Steckkontakt 10 in Steckrichtung 12 gesehen einen recheckigen Querschnitt mit einer Breite von etwa 2,8 mm und eine Tiefe von etwa 0,64 mm auf. Der gezeigte Steckkontakt 10 bildet somit einen Flachstecker. Je nach Anwendung können die Abmessungen des Steckkontakts 10 von den genannten Werten abweichen. Darüber hinaus kann der Steckkontakt auch einen quadratischen oder sogar einen rundlichen Querschnitt aufweisen.

Der Steckkontakt 10 ist zum elektrischen Kontaktieren einer elektrischen Leitung 16 eines spritzgegossenen Schaltungsträgers 18 vorgesehen (Fig. 2). Die Kontaktierung der elektrischen Leitung 16 erfolgt durch Einstecken des Steckkontakts 10 in eine Steckkontaktaufnahme 20 des Schaltungsträgers 18, wie nachfolgend näher erläutert wird. Um das Einführen des Steckkontakts 10 in die Steckkontaktaufnahme 20 zu erleichtern, verjüngt sich der Steckkontakt 10 im Bereich seines in Steckrichtung 12 gesehen vorderen Endes. Darüber hinaus verjüngt sich der gezeigte Steckkontakt 10 auch im Bereich seines in Steckrichtung 12 gesehen hinteren Endes.

Die Form der Steckkontaktaufnahme 20 ist derart an die Gestalt des Steckkontakts 10 angepasst, dass der eingesteckte Steckkontakt 10 mittels Presssitz in der Steckkontaktaufnahme 20 gehalten ist.

Um eine ausreichende Stabilität des Steckkontakts 10 beim Einpressen in die Steckkontaktaufnahme 20 zu gewährleisten, ist der Steckkontakt 10 massiv, d.h. nicht hohl, ausgebildet.

Zur zusätzlichen Sicherung des in die Steckkontaktaufnahme 20 eingeführten Steckkontakts 10 an dem Schaltungsträger 18 sind an gegenüberliegenden und in Steckrichtung 12 weisenden Schmalseiten 22 des Steckkontakts 10 jeweils mehrere in Steckrichtung 12 zueinander beabstandete sägezahnähnliche Vorsprünge 24 vorgesehen. Die Vorsprünge 24 des eingesteckten Steckkontakts wirken mit benachbarten Wänden des Schaltungsträgers 18, welche die Steckkontaktaufnahme 20 begrenzen, zusammen, um die Festigkeit des Presssitzes noch weiter zu erhöhen.

An einer seiner in Steckrichtung 12 weisenden Breitseiten 26 weist der Steckkontakt 10 ferner einen in einem quer zur Steckrichtung 12 gesehen mittleren Bereich der Breitseite 26 angeordneten Kontaktvorsprung 28 auf, welcher um einige Zehntel Millimeter über die Breitseite 26 hinausragt.

Die Breite des Kontaktvorsprungs 28 entspricht mindestens der Breite der elektrischen Leitung 16. Vorzugsweise ist die Breite des Kontaktvorsprungs 28 sogar etwas größer als die der elektrischen Leitung 16 gewählt, um Ungenauigkeiten bei der Positionierung der elektrischen Leitung 16 ausgleichen zu können.

Der in Steckrichtung 12 gesehen vordere Rand 30 des Kontaktvorsprungs 28 verläuft in der Draufsicht auf den Kontaktvorsprung 28 gerade und quer zur Steckrichtung 12 (Fig. 1). Dadurch wird eine Kontaktierung der elektrischen Leitung 16 über deren gesamte Breite erreicht.

Um die elektrische Leitung 16 beim Einstecken des Steckkontakts 10 in die Steckkontaktaufnahme 20 nicht zu beschädigen, ist der Kontaktvorsprung 28 im Profil gesehen an seinem vorderen Rand 30 abgerundet, d.h. der Kontaktvorsprung 28 geht von seiner vom Steckkontakt 10 weg weisenden Oberseite 34 über eine gekrümmte Fläche in die Breiteseite 26 des Steckkontakts 10 über (Fig. 3). Die Oberseite 34 des Kontaktvorsprungs 28 ist im Wesentlichen parallel zu der Breitseite 26 des Steckkontakts 10 orientiert.

Zur Kontaktierung der elektrischen Leitung 16 durch den Steckkontakt 10 wird die elektrische Leitung 16 beispielsweise mittels eines Heißprägeverfahrens so auf ein spritzgegossenes Trägermaterial 36 des Schaltungsträgers 18 aufgebracht, dass sich ein Endabschnitt 38 der elektrischen Leitung 16 bereichsweise über eine Einführöffnung 40 der Steckkontaktaufnahme 20 erstreckt, wie es in Fig. 2 dargestellt ist.

Anschließend wird der Steckkontakt 10 so in die Steckkontaktaufnahme 20 eingeführt, dass der Kontaktvorsprung 28 zu dem Endabschnitt 38 der elektrischen Leitung 16 weist. Beim Einstecken des Steckkontakts 10 wird der Endabschnitt 38 der elektrischen Leitung 16 durch den Kontaktvorsprung 28 in Richtung der Steckkontaktaufnahme 20 umgebogen und an einen die Einführöffnung 40 der Steckkontaktaufnahme 20 begrenzenden Randbereich 42 des Schaltungsträgers 18 angedrückt, wie es in Fig. 3 gezeigt ist.

Die Länge des Endabschnitts 38 ist so gewählt, dass der Endabschnitt 38 im nicht umgebogenen Zustand etwa bis an die zur elektrischen Leitung 16 weisende Breitseite 26 des Steckkontakts 10 heranreicht. Dadurch ist sichergestellt, dass der Endabschnitt 38 beim Einstecken des Steckkontakts 10 nicht in die Steckkontaktaufnahme 20 hineingezogen und von der elektrischen Leitung 16 abgerissen wird.

Bei dem dargestellten Ausführungsbeispiel weist der Randbereich 42 eine schräg zur Steckrichtung 12 orientierte Oberfläche auf, es handelt sich bei dem Randbereich 42 gewissermaßen um eine Fase des Schaltungsträgers 18. Alternativ ist es möglich, den Randbereich 42 mit einem Radius auszubilden, d.h. mit einer gekrümmten Oberfläche zu versehen.

Im vollständig eingesteckten Zustand des Steckkontakts 10 ist der Endabschnitt 38 zwischen dem Kontaktvorsprung 28 und dem Randbereich 42 des Schaltungsträgers 18 eingeklemmt. Der Endabschnitt 38 bildet folglich einen Kontaktabschnitt der elektrischen Leitung 16.

Der Kontaktvorsprung 28 drückt den Endabschnitt 38 im wesentlichen von oben gegen den Randbereich 42 des Schaltungsträgers 18, d.h. die auf die elektrische Leitung 16 ausgeübte Kontaktkraft ist im wesentlichen parallel zur Steckrichtung 12 orientiert.

Somit wird auf rein mechanische Weise ein zuverlässiger elektrischer Kontakt zwischen dem Steckkontakt 10 und der elektrischen Leitung 16 hergestellt, ohne dass dabei die Gefahr einer Beschädigung der elektrischen Leitung 16 besteht.

Um das Umbiegen des Endabschnitts 38 der elektrischen Leitung 16 beim Einführen des Steckkontakts 10 in die Steckkontaktaufnahme 20 zu erleichtern, wird eine nicht dargestellte Heißprägefolie, die zum Aufbringen der elektrischen Leitung 16 auf das Trägermaterial 36 des Schaltungsträgers 18 vorgesehen ist, in einer Umgebung des Endabschnitts 38 eingeschnitten oder perforiert.

Im dargestellten Ausführungsbeispiel erfolgt der Schnitt bzw. die Perforation entlang von den die Einführöffnung 40 der Steckkontaktaufnahme 20 begrenzenden Randbereichendes Schaltungsträgers 18, über welche sich die elektrische Leitung 16 nicht erstreckt.

Durch das Einschneiden bzw. Perforieren der Heißprägefolie wird eine Solltrennstelle geschaffen, die es ermöglicht, den die Einführöffnung 40 überdeckenden Abschnitt der Heißprägefolie als Ganzes in die Steckkontaktaufnahme 20 umzubiegen, ohne dass die Heißprägefolie dabei unkontrolliert einreißt.

Das Einschneiden bzw. Perforieren der Heißprägefolie erfolgt vorzugsweise gleichzeitig mit dem Aufprägen der elektrischen Leitung 16 auf das spritzgegossene Trägermaterial 36 des Schaltungsträgers 18, so dass hierfür kein zusätzlicher Arbeitsgang erforderlich ist.

Obwohl voranstehend lediglich die Kontaktierung eines Endes einer elektrischen Leitung beschrieben wurde, sei darauf hingewiesen, dass es mit Hilfe des erfindungsgemäßen Steckkontakts ebenso möglich ist, eine elektrische Leitung in einem von dem Leitungsende entfernten Bereich zu kontaktieren.

Erforderlich ist hierfür lediglich, dass die elektrische Leitung sich über eine-Steckkontaktaufnahme hinweg erstreckt und einen verbreiterten Bereich aufweist, der neben der Steckkontaktaufnahme einen die Steckkontaktaufnahme umgebenden Oberflächenbereich des Schaltungsträgers abdeckt, durch welchen auch bei eingestecktem Steckkontakt Strom fließen kann.

Um ein Einreißen der elektrischen Leitung beim Einstecken des Steckkontakts zu verhindern, muss außerdem eine über der Steckkontaktaufnahme positionierte Durchgangsöffnung für den Steckkontakt oder zumindest eine die Durchgangsöffnung begrenzende Solltrennlinie in die elektrische Leitung eingebracht werden. Ferner müssen zwei von der Durchgangsöffnung ausgehende, zueinander beabstandete Solltrennlinien vorgesehen werden, welche die Seiten des durch den Kontaktvorsprung des Steckkontakts umzubiegenden und zu kontaktierenden Kontaktabschnitts der elektrischen Leitung definieren.

### Bezugszeichenliste

- 10: Steckkontakt
- 12: Steckrichtung
- 16: elektrische Leitung
- 18: Schaltungsträger
- 20: Steckkontaktaufnahme
- 22: Schmalseite
- 24: Vorsprung
- 26: Breitseite
- 28: Kontaktvorsprung
- 30: vorderer Rand
- 34: Oberseite
- 36: Trägermaterial
- 38: Endabschnitt
- 40: Einführöffnung
- 42: Randbereich

## Patentansprüche

1. Steckkontakt (10) zur elektrischen Kontaktierung einer elektrischen Leitung (16) eines spritzgegossenen Schaltungsträgers (18), wobei der Steckkontakt (10) einen Kontaktvorsprung (28) zur Ausübung einer Kontaktkraft (41) auf einen in Richtung einer Steckkontaktaufnahme (20) des Schaltungsträgers (18) umgebogenen Kontaktabschnitt (40) der elektrischen Leitung (16) aufweist,
**dadurch gekennzeichnet, dass**
der Steckkontakt (10) ein Flachstecker ist,
der Kontaktvorsprung (28) an einer sich in Steckrichtung (12) erstreckenden Breitseite (26) des Steckkontakts (10) angeordnet ist und
an wenigstens einer sich in Steckrichtung (12) erstreckenden Schmalseite (22) des Steckkontakts (10) ein Sicherungsmittel (24) zur Sicherung des Steckkontakts (10) in der Steckkontaktaufnahme (20) vorgesehen ist.

2. Steckkontakt (10) nach Anspruch 1,
**dadurch gekennzeichnet, dass**
der Kontaktvorsprung (28) eine Breite aufweist, die mindestens so groß wie die Breite des Kontaktabschnitts (40) ist.

3. Steckkontakt (10) nach Anspruch 1 oder 2,
**dadurch gekennzeichnet, dass**
das Sicherungsmittel mehrere sägezahnähnliche Vorsprünge (24) umfasst.

4. Verfahren zur elektrischen Kontaktierung einer elektrischen Leitung (16) eines spritzgegossenen Schaltungsträgers (18) durch einen Steckkontakt (10), insbesondere durch einen Steckkontakt (10) nach einem der vorherigen Ansprüche, bei welchem Verfahren die elektrische Leitung (16) so auf dem Schaltungsträger (18) angeordnet wird, dass sich ein Kontaktabschnitt (38) der elektrischen Leitung (16) zumindest abschnittsweise über eine in dem Schaltungsträger (18) vorgesehene Steckkontaktaufnahme (20) erstreckt, und der Steckkontakt (10) derart in die Steckkontaktaufnahme (20) eingesteckt wird, dass der Kontaktabschnitt (38) der elektrischen Leitung (16) durch einen Kontaktvorsprung des Steckkontakts (10) in Richtung der Steckkontaktaufnahme (20) umgebogen wird und ausschließlich durch den Kontaktvorsprung des in die Steckkontaktaufnahme (20) eingesteckten Steckkontakts (10) eine Kontaktkraft (41) auf den umgebogenen Kontaktabschnitt (38) der elektrischen Leitung (16) ausgeübt wird.

5. Verfahren nach Anspruch 4,
**dadurch gekennzeichnet, dass**
der umgebogene Kontaktabschnitt (38) durch den Kontaktvorsprung des eingesteckten Steckkontakts (10) an einen die Einführöffnung der Steckkontaktaufnahme (20) begrenzenden abgeschrägten oder abgerundeten Randbereich (42) des Schaltungsträgers (18) angedrückt wird.

6. Verfahren nach einem der Ansprüche 4 oder 5,
**dadurch gekennzeichnet, dass**
die elektrische Leitung (16) mittels eines Heißprägeverfahrens auf ein Trägermaterial (36) des Schaltungsträgers (18) aufgebracht wird.

7. Verfahren nach Anspruch 6,
**dadurch gekennzeichnet, dass**
eine die elektrische Leitung (16) tragende Heißprägefolie, insbesondere während des Heißprägevorgangs, in einem Umgebungsbereich des Kontaktabschnitts (38) der elektrischen Leitung (16) und insbesondere entlang von Rändern des Schaltungsträgers (18), welche eine Einführöffnung (40) der Steckkontaktaufnahme (20) begrenzen, eingeschnitten oder perforiert wird.

8. Spritzgegossener Schaltungsträger (18) mit einer elektrischen Leitung (16) und einem elektrischen Steckkontakt (10) gemäß einem der Ansprüche 1 bis 3, welcher in eine Steckkontaktaufnahme (20) des Schaltungsträgers (18) eingesteckt ist und durch einen Kontaktvorsprung zur elektrischen Kontaktierung der elektrischen Leitung (16) eine Kontaktkraft (41) auf einen in Richtung der Steckkontaktaufnahme (20) umgebogenen Kontaktabschnitt (38) der elektrischen Leitung (16) ausübt.

9. Schaltungsträger (18) nach Anspruch 8,
**dadurch gekennzeichnet, dass**
der Kontaktabschnitt (38) der elektrischen Leitung (16) durch den Kontaktvorsprung (28) des Steckkontakts (10) an einen die Einführöffnung (40) der Steckkontaktaufnahme (20) begrenzenden abgeschrägten oder abgerundeten Randbereich (42) des Schaltungsträgers (18) angedrückt ist.

## Claims

1. A plug-in contact (10) for the electrical contacting of an electrical lead (16) of an injection molded circuit substrate (18), wherein the plug-in contact (10) has a contact projection (28) for the exertion of a contact force (41) onto a contact section (40) of the electrical lead (16) bent over in the direction of a seat (20) of the circuit substrate (18) for receiving the plug-in contact,
**characterized in that** the plug-in contact is a flat plug;
**in that** the contact projection (28) is arranged at a broad side (26) of the plug-in contact (10) extending in the plug-in direction (12); and
**in that** a securing means (24) is provided at a narrow side (22) of the plug-in contact (10) extending in the plug-in direction (12) for the securing of the plug-in contact (10) in the seat (20) for receiving the plug-in contact.

2. A plug-in contact (10) in accordance with claim 1, **characterized in that** the contact projection (28) has a width which is at least as large as the width of the contact section (40).

3. A plug-in contact (10) in accordance with claim 1 or claim 2, **characterized in that** the securing means comprises a plurality of projections (24) similar to saw teeth.

4. A method for the electrical contacting of an electrical lead (16) of an injection molded circuit substrate (18) by a plug-in contact (10), in particular by a plug-in contact (10) in accordance with any one of the preceding claims, in which method the electrical lead (16) is arranged on the circuit substrate (18) such that a contact section (38) of the electrical lead (16) extends at least sectionally over a seat (20) for receiving the plug-in contact provided in the circuit substrate (18) and the plug-in contact (10) is plugged into the seat (20) for receiving the plug-in contact such that the contact section (38) of the electrical lead (16) is bent over by a contact projection of the plug-in contact (10) in the direction of the seat (20) for receiving the plug-in contact and a contact force (41) is exerted onto the bent over contact section (38) of the electrical lead (16) by the contact projection of the plug-in contact (10) plugged into the seat (20) for receiving the plug-in contact.

5. A method in accordance with claim 4, **characterized in that** the bent over contact section (38) is pressed by the contact projection of the plugged in plug-in contact (10) toward a chamfered or rounded rim region (42) of the circuit substrate (18) bounding the introductory opening of the seat (20) for receiving the plug-in contact.

6. A method in accordance with one of the claims 4 or 5, **characterized in that** the electrical lead (16) is applied to a substrate material (36) of the circuit substrate (18) by means of a hot stamping method.

7. A method in accordance with claim 6, **characterized in that** a hot stamping foil carrying the electrical lead (16) is cut or perforated in a surrounding region of the contact region (38) of the electrical lead (16) and in particular along rims of the circuit substrate (18) which bound an introductory opening (40) of the seat (20) for receiving the plug-in contact, in particular during the hot stamping procedure.

8. An injection molded circuit substrate (18) comprising an electrical lead (16) and an electrical plug-in contact (10), in particular in accordance with any one of the claims 1 to 3, which is plugged into a seat (20) for receiving the plug-in contact of the circuit substrate (18) and exerts a contact force (41) onto a contact section (38) of the electrical lead (16) bent over in the direction of the seat (20) for receiving the plug-in contact by a contact projection for the electrical contacting of the electrical lead (16).

9. A circuit substrate (18) in accordance with claim 8, **characterized in that** the contact section (38) of the electrical lead (16) is pressed by the contact projection (28) of the plug-in contact (10) toward a chamfered or rounded rim region (42) of the circuit substrate (18) bounding the introductory opening (40) of the seat (20) for receiving the plug-in contact.

## Revendications

1. Contact mâle (10) pour la mise en contact électrique d'un conducteur électrique (16) d'un support de circuit (18) moulé par injection, le contact mâle (10) comportant une saillie de contact (28) pour exercer une force de contact (41) sur un segment de contact (40), replié en direction d'un logement de contact mâle du support de circuit (18), du conducteur électrique (16),
**caractérisé en ce que**
le contact mâle (10) est un connecteur plat, la saillie de contact (28) est disposée sur un grand côté (26) s'étendant dans la direction d'enfichage (12), du contact mâle (10), et
il est prévu un moyen de blocage (24) sur au moins un petit côté (22), s'étendant dans la direction d'enfichage (12), du contact mâle (10), pour bloquer le contact mâle (10) dans le logement de contact mâle (20).

2. Contact mâle (10) selon la revendication 1,
**caractérisé en ce que**
la saillie de contact (28) présente une largeur qui est au moins égale à la largeur du segment de contact (40).

3. Contact mâle (10) selon la revendication 1 ou 2,
**caractérisé en ce que**
le moyen de blocage comprend plusieurs saillies (24) de type dents de scie.

4. Procédé pour la mise en contact électrique d'un conducteur électrique (16) d'un support de circuit (18) moulé par injection par un contact mâle (10), en particulier par un contact mâle (10) selon l'une des revendications précédentes, dans lequel procédé le conducteur électrique (16) est disposé sur le support de circuit (18) de manière qu'un segment de contact (38) du conducteur électrique (16) s'étende au moins par endroits sur un logement de contact mâle (20) prévu dans le support de circuit (18), et le contact mâle (10) est enfiché dans le logement de contact mâle (20) de manière que le segment de contact (38) du conducteur électrique (16) soit replié par une saillie de contact du contact mâle (10) en direction du logement de contact mâle (20), et qu'une force de contact (41) soit exercée sur le segment de contact (38) replié du conducteur électrique (16), exclusivement par la saillie de contact du contact mâle (10) enfiché dans le logement de contact mâle (20).

5. Procédé selon la revendication 4,
**caractérisé en ce que**
le segment de contact (38) replié par la saillie de contact du contact mâle (10) enfiché, est pressé contre une zone de bordure (42) du support de circuit (18), chanfreinée ou arrondie, limitant l'ouverture d'introduction du logement de contact mâle (20).

6. Procédé selon l'une des revendications 4 ou 5,
**caractérisé en ce que**
le conducteur électrique (16) est appliqué par un procédé d'estampage à chaud sur un matériau de support (36) du support de circuit (18).

7. Procédé selon la revendication 6,
**caractérisé en ce que**
une feuille d'estampage à chaud, portant le conducteur électrique (16), est entaillée ou perforée, en particulier pendant le processus d'estampage à chaud, dans une zone environnante du segment de contact (38) du conducteur électrique (16), et en particulier le long de bords du support de circuit (18), lesquels délimitent une ouverture d'introduction (40) du logement de contact mâle (20).

8. Support de circuit (18) moulé par injection avec un conducteur électrique (16) et un contact mâle électrique (10) selon l'une des revendications 1 à 3, qui est enfiché dans un logement de contact mâle (20) du support de circuit (18), et exerce une force de contact (41), par une saillie de contact pour la mise en contact électrique du conducteur électrique (16), sur un segment de contact (38), replié en direction du logement de contact mâle (20), du conducteur électrique (16).

9. Support de circuit (18) selon la revendication 8,
**caractérisé en ce que**
le segment de contact (38) du conducteur électrique (16) est pressé, par la saillie de contact (28) du contact mâle (10), contre une zone de bordure (42) du support de circuit (18), chanfreinée ou arrondie, limitant l'ouverture d'introduction (40) du logement de contact d'enfichage (20).
